# EUROPEAN PATENT SPECIFICATION

(11) **EP 3 821 134 B1**
(45) Date of publication and mention of the grant of the patent: **21.12.2022**
(21) Application number: 19736449.0
(22) Date of filing: 27.06.2019
(51) Int. Cl.: F04D 27/02, F04D 29/70, H01L 21/67, F04D 19/04

(54) **VACUUM PUMP WITH THROUGH CHANNEL AND VACUUM CHAMBER**
VAKUUMPUMPE MIT DURCHGANGSKANAL UND VAKUUMKAMMER
POMPE À VIDE AVEC CANAL TRAVERSANT ET CHAMBRE À VIDE

(30) Priority: 09.07.2018 GB 201811230
(43) Date of publication of application: 19.05.2021
(73) Proprietor: Edwards Limited, Burgess Hill, Sussex RH15 9TW (GB)
(72) Inventor: BAILEY, Christopher Mark, Burgess Hill, Sussex RH15 9TW (GB); STONES, Ian David, Burgess Hill, Sussex RH15 9TW (GB)
(74) Representative: Norton, Ian Andrew
(86) International application number: PCT/GB2019/051809
(87) International publication number: WO 2020/012154

(56) References cited:
- JP-A- 2001 351 870
- JP-A- 2003 071 271
- JP-A- 2012 104 488

## Description

### FIELD OF THE INVENTION

The field of the invention relates to vacuum pumps and vacuum chambers evacuated by such pumps.

### BACKGROUND

Vacuum pumps such as disclosed in JP2003071271 A and JP2001351870 A are used to evacuate chambers such as semiconductor processing chambers for manufacturing semiconductor wafers. In such chambers the symmetry and the uniformity of the gas flow is important; a lack of symmetry which leads to non-uniform gas flow produces corresponding non-uniformities on the wafers.

It is known to provide a chamber with a turbomolecular pump arranged centrally under the chamber and with the pendulum valve replaced with a poppet valve. Such an arrangement provides the pump, valve and chamber all on the same centre line. This gives an improved even gas flow around the wafer and reduces asymmetrical effects caused by locating the pump and the exhaust port to the pump off to one side of the wafer, and the compounding effects caused by a pendulum valve occluding the pump inlet from one side.

Such an arrangement does not however result in symmetry about any diameter of the circular substrate support, because the valve plate requires supports and the substrate support or wafer chuck also has some support and requires cooling, heating and power to be supplied. The valve plate drive posts are small in diameter and may have a lesser effect. The chuck supports are more substantial as they carry the cooling, heating and power to the electrostatic chuck cathode.

It would be desirable to provide a vacuum pump and chamber arranged such that more uniform gas flow across a substrate is provided.

### SUMMARY

A first aspect provides a vacuum pump comprising: a rotor; and a stator; an inlet for receiving gas during operation; and an exhaust for exhausting said gas; a conduit defining an axial passage extending through said pump from an opening in a base of said pump to an opening axially beyond said pump inlet, said rotor and said stator extending around said conduit; and a plate configured to obscure said inlet by a controllable amount and to thereby control an inlet conductance of said pump; a shaft for mounting said plate, said shaft being hollow and extending around said passage; said plate comprising a hole in a central portion through which said conduit extends.

The inventors of the present invention recognised that many processes performed within vacuum chambers such as semiconductor etch processes require uniform gas flow across a substrate if a high quality result is to be achieved. Mounting the substrate above the inlet of the vacuum pump helps to provide uniform gas flow across the substrate; however the support member to some extent and more importantly the power and control supplied to the substrate disturb the gas flow and decrease the uniformity.

A vacuum pump with an axial passage extending through the pump provides a central pathway for connectors to the substrate mount, allowing the substrate mount to be provided with the necessary connections centrally and resulting in a more uniform gas flow across the substrate.

Furthermore, the addition of a valve plate that obscures the pump inlet by a controllable amount allows for uniform flow while providing fast pressure control and reduced particle generation and shedding. Furthermore, it also provides for symmetric flow around the plate and reduces non-uniformities in the gas flow across the wafer. It should be noted that although the plate may be a flat circular structure, it may also have other forms, such as a conical form. In general it is advantageous if it has a circular cross section to improve the uniformity of the gas flow.

The arrangement of the hollow pump and valve plate may allow flow directing formations such as baffles which are conventionally used to compensate for irregularities in gas flow within the chamber to be dispensed with or at least reduced in number, thereby reducing obstacle to the gas flow which may act both to impede the flow and as a source of particle shedding.

A hollow pump having a plate at least partially obscuring the pump inlet, axial movement of the plate providing inlet conductance control provides an effective and fast control of the inlet conductance to the pump and thus, the pressure within the chamber and a more uniform gas flow over the substrate.

The plate at least partially obscures the inlet and its movement causes the inlet conductance to vary as the gas flows around the edge of the plate. In some cases, the plate may extend beyond the pump's inlet in all axial positions while in others it may extend beyond the inlet in some axial positons. Axial movement is movement substantially parallel to the shaft of the pump. The plate is mounted on a shaft, the shaft being hollow and extending around the conduit defining the passage.

In some embodiments, said plate is mounted on an end of said rotor towards said inlet, said rotor being mounted to be movable in an axial direction with respect to said stator. In this case the shaft that the plate is mounted on is the rotor shaft.

In some embodiments, said rotor is mounted to or positioned within the pump via electro-magnetic bearings, a current supplied to electro-magnets associated with said bearings controlling an axial position of said rotor and said plate.

Some pumps such as turbomolecular pumps have magnetically levitated rotors and therefore have some control of the axial position of the rotor. This magnetic levitation is used to allow the pump to rotate at high speed with low friction and without the need for lubricants which may contaminate the vacuum.

Conventionally control of the magnetic levitation is used to set the position of the rotor relative to the stator at an optimum or preferred point that may be selected either as the mid-point between the impellers to maximise clearances and reduce the chances of impellers clashing, or where axial clearances affect pumping efficiency, where for example the turbo pump is backed by a Siegbahn drag stage mounted on the same shaft, at a point that provides greatest pumping efficiency. Embodiments seek to provide this axial control not to provide one selected preferred position of the rotor but rather to provide a choice of different axial positions to provide different inlet conductances and in some cases pumping capacities allowing the axial position to be used in control of the pressure generated by the pump. Control of axial positon can in this way be used to provide rapid changes in pressure produced in a chamber by such a pump, without the need for many additional parts allowing the pump to retain a low size, relatively low cost and not have an increase in servicing requirements. Furthermore, symmetric flow around the plate is provided and uniform flow is conserved. Thus, a cost effective, efficient and symmetric means of controlling pressure generated by the pump is achieved.

In some embodiments, said pump comprises an actuator associated with said shaft for varying an axial position of said shaft and said plate.

It may be advantageous to allow for separate control of the axial position of the plate and the rotor. In this way the inlet conductance control is decoupled from the optimal rotational position for the pump impellers. Furthermore, a greater range of axial positions may be possible as there is no constraint in axial positions due to the potential of rotor and stator impellers clashing. The advantages of fast pressure control and symmetric flow around the plate are also provided in such a system. In this case the shaft mounting the plate is not the rotor shaft, but is a separate shaft that is itself axially controllable.

In some embodiments, said plate comprises an O-ring on a surface facing said pump inlet, while in others there is no O-ring.

Where the plate is mounted on the rotor, then it will be rotating with the rotor and it may not be practical to provide a seal on the rotor plate. However, where it is mounted on a separate shaft then axial movement of the plate allows surfaces of the plate and pump inlet or chamber outlet to abut. In such a scenario an O-ring seal on a lower surface of the plate can be used to effectively isolate the pump and the chamber from each other. This may allow the chamber to be sealed and the vacuum retained even when the pump is not operational.

In other embodiments no O-ring seal may be provided. One potential problem with an O-ring seal arises due to the speed of axial movement of the plate that is required to provide fast pressure control. High acceleration of the plate may cause the O-ring seal to become dislodged and may be a limiting factor on the acceleration of the plate. Thus, it may be advantageous for the plate not to have such a seal. In this regard in many systems, when the turbo pump is removed for cleaning, the valve and chamber may also be cleaned. In such systems the need to be able to seal the chamber from the pump may not be required and thus, it may be advantageous not to use an O-ring.

In some embodiments, said vacuum pump comprises control circuitry configured to control an axial position of said plate.

In other embodiments, the control circuitry for controlling the axial position may not be a part of the vacuum pump.

In some embodiments, said control circuitry comprises an input configured to receive a signal indicative of a pressure produced by said vacuum pump, said control circuitry being configured to control said axial position of said plate in dependence upon a value of said signal.

As the axial position of the plate can be used to control the inlet conductance and thus, the pressure produced by the vacuum pump, the control circuitry may in some cases use a feedback loop and a signal received from a sensor indicating a pressure produced by the pump to provide effective control of the pressure. Where the pump is pumping a vacuum chamber this may be a pressure measured in the chamber, perhaps adjacent to or at the pump inlet. In some cases a feedforward loop may be used with a desired pressure being equated to a particular axial position. The relative axial positions are initially set to the value related to the desired pressure and the axial position is adjusted if required in response to readings from the pressure sensor. Where some adjustment is needed an updated axial position is stored for that pressure.

In some embodiments, the vacuum pump further comprises a pump housing, said pump housing comprising an outer cylinder, an inner cylinder and a base perpendicular to and connecting said inner and outer cylinders, said inner cylinder comprising said conduit and extending further from said base than said outer cylinder.

As noted previously an advantage with having a passage through the pump is that any connections to a substrate mount, such as a cathode, may pass through the pump and arrive underneath the substrate mount towards its centre. In some embodiments, an end of said conduit towards said pump inlet comprises mounting means for mounting a substrate mount such as a cathode. This allows the substrate to be mounted centrally above the pump inlet without the need for separate substrate supports which themselves may disrupt uniform gas flow.

In some embodiments, said pump comprises inner impellers mounted to a shaft coaxial with and extending around said axial passage and outer impellers mounted to a cylinder extending around said inner and outer impellers.

In some embodiments, said inner impellers and shaft are rotatably mounted and comprise said rotor and said outer impellers and larger diameter cylinder comprise said stator.

In other embodiments, said inner impellers and shaft comprise said stator and said outer impellers and larger diameter cylinder are rotatably mounted.

As the pump has a passage through it, it may be convenient to rotate the outer impellers and keep the inner impellers still. This may make mounting of the motor simpler and also allow the valve plate to be mounted on the shaft on which the inner impellers are mounted. The shaft may form the conduit and axial movement of this shaft or conduit controls the inlet conductance. In this case the shaft will also move the impellers axially but it will not rotate and the plate may therefore have an O-ring on a lower surface.

In still other embodiments, both said inner and outer impellers are mounted for rotation in opposite directions.

In some embodiments said vacuum pump comprises a turbomolecular pump and said impellers comprise blades. In other embodiments the pump may be a Siegbahn drag stage and the impellers may be disks or it may be a turbo pump backed by a Siegbahn stage. Embodiments are appropriate to different types of vacuum pumps particularly those which have centrally mounted shafts.

In some embodiments, said pump comprises: a flow control unit having an inlet in fluid connection with said exhaust of said pump, said flow control unit being configured to provide variable conductance at said exhaust and thereby control fluid pressure at said exhaust of said pump.

An alternative and/or additional way of controlling the pressure in the chamber provided by the pump is to throttle the exhaust by varying the outlet conductance rather than or as well as providing a plate for varying the inlet conductance. This may be done at the exhaust of the turbomolecular pump upstream of any backing pump.

In some embodiments, said flow control unit further comprises control circuitry configured to control a speed of said pump in conjunction with controlling said conductance.

In order to provide a greater range of chamber pressures without exceeding the thermal limit and/or motor stall limit of the turbomolecular pump unit it may be advantageous to provide control of the outlet conductance of the pump in conjunction with control of its rotational speed. In this way a greater range of pressure control can be provided while still protecting the pump.

A second aspect provides, a vacuum arrangement comprising an outlet for a vacuum chamber and a turbomolecular vacuum pump according to a first aspect.

A third aspect provides a vacuum chamber comprising a vacuum arrangement according to a second, said vacuum chamber comprising a substrate mount for mounting a substrate, said substrate mount being mounted on an end of said conduit

In some embodiments, said substrate mount comprises a cathode.

In some embodiments, said substrate mount extends beyond said conduit over at least a portion of said pump inlet.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figure 1 shows a pump and base of a vacuum chamber according to an embodiment;
Figure 2 shows a pump and base of a vacuum chamber according to a further embodiment; and
Figure 3 shows a pump with valve plate mounted on the rotor and base of a vacuum chamber according to an embodiment.

### DESCRIPTION OF THE EMBODIMENTS

Before discussing the embodiments in any more detail, first an overview will be provided.

A turbo pump with a hole in the middle can be used in conjunction with a poppet valve, also with such a hole. This allows in some embodiments the drive posts that support it to be located on the outer diameter of the hole (and so within the inside diameter of the rotor). In such a case there would be no, or at least very low interruption to gas flow - and therefore nothing to cause any asymmetry. The diameter of the hole may be beween 10 and 45 cms. A hole of 10cm or more is sufficient for routing cables to the substrate mount, while a larger hole may be sufficient to surround the whole substrate, allowing the substrate to be within the diameter of the hole and not impeding gas flow into the pump. In other embodiments it may be advantageous for the substrate mount to extend beyond the hole and over the pump inlet as in such a case, the substrate mount provides some protection to the sample from particles deflected by the rotating impellers of the pump back into the chamber.

A poppet valve can be used for either pressure control or isolation or for both. Isolation between the turbo pump and the chamber is provided to allow the turbo pump to be removed without raising the chamber pressure to atmospheric.

For critical etch on small feature sizes applications, maintenance procedures require turbo pumps and valves to be removed and replaced together as one piece. This allows the isolation function to be moved to between the turbo pump exhaust and the fore line. There may, therefore, be no requirement for the poppet valve to provide isolation with a good seal.

Not having an O-ring seal may be advantageous as a factor which limits the speed at which the valve can move is the retention of the O-ring in the valve plate. Therefore, elimination of the O-ring removes that limitation and hence allows the valve to move faster. The valve may seal adequately for functional purposes without an O-ring.

The diameters of the pump and valve and opening in the chamber body can be arranged such that the pump inlet can be a close as possible to the substrate support. The feedthrough channel within the substrate support carries electrical power, heating / cooling media, control and measurement signals to and from the substrate support. Since the substrate support is at vacuum and the lower end of the channel is at atmospheric pressure the feedthrough channel is sealed.

The lower end of the substrate support tube can be attached to the base of the pump which in turn can be attached to the chamber body via the pump side walls.

The valve is driven by an actuator or actuators which drive the support which comprises a shaft or tube.

In some embodiments the rotor may be driven from the outside - rather than the inside. In such an embodiment the fixed impellers are fixed to an inner stator tube and the motor rotor is around the outside of the spinning impellers. In such a case, the inner stator tube may extend beyond the pump inlet and provide a conduit for power and control cables to a substrate mount. In some embodiments both sets of impellers are rotated. The impellers may be blades in a turbomolecular pump, or discs in a Siegbahn pump.

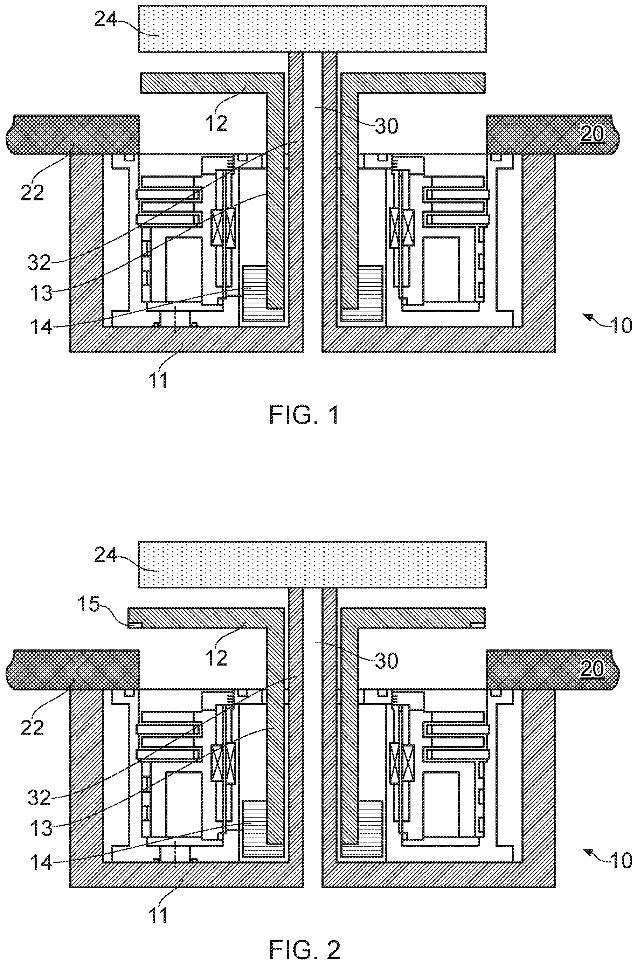

Figure 1 shows a vacuum pump arrangement according to an embodiment. Vacuum pump 10 is connected to the base 22 of chamber 20. Vacuum pump 10 which in this embodiment is a turbomolecular pump has a conduit or feedthrough channel 30 that extends through the pump, from the pump base 11 to the substrate support or cathode 25 that mounts the wafer. The conduit 30 provides a space through which electrical cables can pass to the substrate support 24. In this way the cables arrive under the centre of the substrate and do not provide asymmetry to the chamber arrangement, thereby not impeding uniform gas flow over the substrate.

In this embodiment pump 10 also comprises a poppet valve plate 12 which is mounted on a shaft 13 that extends around the conduit 32 and is axially moveable via a valve position actuator 14. The poppet valve plate 12 obscures the outlet of the chamber 20 and the inlet to the pump 10 by varying amounts depending on its axial position. The axial position is controlled via the valve position actuator 14. This valve position actuator is controlled by control circuitry not shown which may have an input from a pressure sensor within the chamber and is able to vary the position of the valve plate and thereby change the inlet conductance and thus, the pressure within the chamber. Pump 10 has base 11 which is connected to the conduit or support tube 32 which surrounds the feedthrough channel 30. The conduit or support tube 32 extends beyond the side walls of the pump 10 into the chamber and provides the support for the substrate support 24. Thus, the chuck or substrate support 24 is both supported centrally and has a central feed for power and control supply leads.

Although a turbomolecular pump is shown in this example other vacuum pumps with a central shaft such as Holweck or Siegbahn pumps are also applicable and may comprise a hole through the centre and an axially movable valve plate.

Figure 2 shows a similar embodiment but in this embodiment the valve plate 12 has an O-ring 15 on its lower surface. This O-ring is forms a seal with the chamber floor 22 when the valve plate 12 is in its lowest axial position. In this way, the valve plate 12 is able to seal the chamber and allow the vacuum in the chamber to be retained. In the embodiment of Figure 1 there is no O-ring.

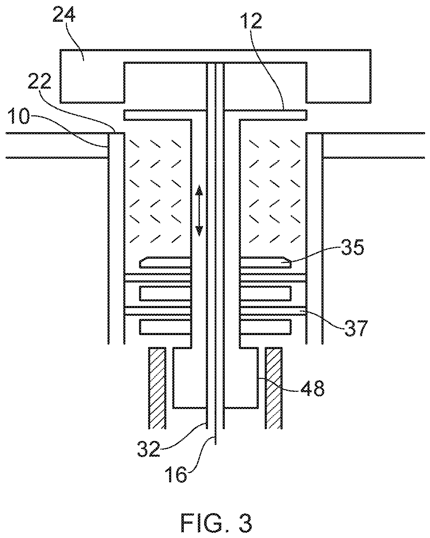

Figure 3 shows a further embodiment. In this embodiment the rotor shaft has the valve plate 12 affixed to its upper end. The rotor is magnetically levitated via spindle bearings 48 and control circuitry (not shown) in conjunction with the magnetic levitation system is used to control the vertical or axial position of the rotor and thus, the position of the valve plate 12. Thus, the inlet conductance and pressure in the chamber can be controlled. The range of vertical movement available will depend on the magnetic design of the bearing, and the magnetic limitations of turbo blade clearance and where there is a Siegbahn drag stage the Siegbahn clearance and performance characteristics. In this embodiment there is a Siegbahn drag stage with rotor blades 35 and stator blades 37. Relative axial movement of the rotor and stator change the relative distance between these blades and affects the performance of the drag stage.

In this embodiment, the substrate or cathode support 24 has been provided with a recess into which the valve plate 12 can fit. The pump has a feed through channel 12 within the rotor shaft through which cables 16 are routed to connect with substrate mount or substrate support 24.

In other embodiments, in addition to having a valve plate mounted for axial movement to vary the inlet conductance of the chamber the outlet conductance of the turbo pump may be varied by providing a flow control means between the exhaust of the turbo pump and the backing pump. This can be used to provide pressure control in the chamber in addition to the valve plate and may be used in conjunction with a turbo pump with feedthrough channel to evacuate and control the pressure in a vacuum chamber while providing power and control to a substrate holder mounted above the inlet of the turbo pump via centrally located cables so as to provide a reduced disturbance to gas flow.

Although illustrative embodiments of the invention have been disclosed in detail herein, with reference to the accompanying drawings, it is understood that the invention is not limited to the precise embodiment and that various changes and modifications can be effected therein by one skilled in the art without departing from the scope of the invention as defined by the appended claims.

### REFERENCE SIGNS

- 10: Turbomolecular pump
- 11: pump base
- 12: valve plate
- 13: valve support
- 14: valve position actuator
- 15: O-ring
- 16: cables
- 20: vacuum chamber
- 22: vacuum chamber base
- 24: substrate mount
- 30: feedthrough channel
- 32: conduit
- 35: rotor blade
- 37: stator blade
- 48: magnetically levitated spindles

## Claims

1. A vacuum pump (10) comprising:
a rotor; and
a stator;
an inlet for receiving gas during operation; and
an exhaust for exhausting said gas;
a conduit (32) defining an axial passage extending through said pump (10) from an opening in a base (11) of said pump to an opening axially beyond said pump inlet, said rotor and said stator extending around said conduit (32), **characterised in that**
a plate (12) is configured to obscure said inlet by a controllable amount and thereby control an inlet conductance of said pump (10);
a shaft (13) for mounting said plate (12) is hollow and extends around said passage;
said plate (12) comprises a hole in a central portion through which said conduit (32) extends.

2. A vacuum pump (10) according to claim 1, wherein
said plate (12) comprises an axially movable plate extending in at least some axial positions beyond an inlet of said pump (10), a change in axial position of said plate (12) providing a change in inlet conductance of gas to said vacuum pump, preferably wherein said pump comprises an actuator (14) associated with said shaft (13) for varying an axial position of said shaft (13) and said plate (12).

3. A vacuum pump (10) according to any preceding claim, wherein said plate (12) comprises an O-ring (15) on a surface facing said pump inlet.

4. A vacuum pump (10) according to any preceding claim, wherein said shaft (13) comprises said rotor shaft, said plate (12) being mounted on an end of said rotor towards said inlet, said rotor being mounted to be movable in an axial direction with respect to said stator.

5. A vacuum pump (10) according to claim 4, wherein said rotor is positioned within said pump via electro-magnetic bearings, a current supplied to electro-magnets associated with said bearings controlling an axial position of said rotor and said plate (12).

6. A vacuum pump (10) according to any preceding claim, wherein said pump comprises inner impellers mounted to said shaft coaxial with and extending around said axial passage and outer impellers mounted to a cylinder extending around said inner and outer impellers, preferably wherein said vacuum pump comprises a turbomolecular pump and said impellers comprise blades.

7. A vacuum pump (10) according to claim 6 when dependent on claim 4 or 5, wherein said inner impellers and shaft (13) are rotatably mounted and comprise said rotor and said outer impellers and larger diameter cylinder comprise said stator.

8. A vacuum pump (10) according to claim 6, when dependent on any one of claims 1 to 3, wherein said inner impellers and shaft (13) comprise said stator and said outer impellers and larger diameter cylinder are rotatably mounted.

9. A vacuum pump (10) according to claim 6, wherein both said inner and outer impellers are mounted for rotation in opposite directions.

10. A vacuum pump (10) according to any one preceding claim, wherein said vacuum pump comprises control circuitry configured to control an axial position of said plate (12), preferably wherein said control circuitry comprises an input configured to receive a signal indicative of a pressure produced by said vacuum pump, said control circuitry being configured to control said axial position of said plate in dependence upon a value of said signal.

11. A vacuum pump (10) according to any preceding claim, comprising a pump housing, said pump housing comprising an outer cylinder, an inner cylinder and a base (11) perpendicular to and connecting said inner and outer cylinders, said inner cylinder comprising said conduit (32) and extending further from said base (11) than said outer cylinder.

12. A vacuum pump (10) according to any preceding claim, wherein an end of said conduit (32) towards said pump inlet comprises mounting means for supporting a substrate mounting device (24).

13. A vacuum pump (10) according to any preceding claim, wherein said pump comprises:
a flow control unit having an inlet in fluid connection with said exhaust of said pump, said flow control unit being configured to provide variable conductance at said exhaust and thereby control fluid pressure at said exhaust of said pump, preferably wherein said flow control unit further comprises control circuitry configured to control a speed of said pump in conjunction with controlling said conductance at said exhaust.

14. A vacuum arrangement comprising an outlet for a vacuum chamber and a turbomolecular vacuum pump (10) according to any preceding claim, an inlet of said turbomolecular pump being connected to said outlet for said vacuum chamber (20).

15. A vacuum chamber (20) comprising a vacuum arrangement according to claim 14, wherein said substrate mount (24) extends beyond said conduit (32) over at least a portion of said pump inlet.

## Patentansprüche

1. Vakuumpumpe (10) mit:
einem Rotor; und
einem Stator;
einem Einlass zur Aufnahme von Gas während des Betriebs; und
einem Auslass zum Ausstoßen des Gases;
einer Leitung (32), die einen axialen Kanal definiert, der von einer Öffnung in einer Basis (11) der Pumpe zu einer Öffnung axial jenseits des Pumpeneinlasses durch die Pumpe (10) verläuft, wobei der Rotor und der Stator um die genannte Leitung (32) herum verlaufen,
**dadurch gekennzeichnet, dass**
eine Platte (12) dafür konfiguriert ist, den Einlass um ein steuerbares Maß zu versperren und dadurch eine Einlassleitfähigkeit der Pumpe (10) zu steuern;
ein Schaft (13) zur Montage der Platte (12) hohl ist und um den genannten Kanal herum verläuft; die genannte Platte (12) eine Öffnung in einem mittigen Teil aufweist, durch welche die Leitung (32) verläuft.

2. Vakuumpumpe (10) nach Anspruch 1, wobei
die Platte (12) eine axial bewegliche Platte umfasst, die in mindestens einigen axialen Positionen über einen Einlass der Pumpe (10) hinaus verläuft, wobei eine Veränderung der axialen Position der Platte (12) eine Veränderung der Einlass-Gasleitfähigkeit in die Vakuumpumpe bewirkt, wobei vorzugsweise die Pumpe ein Betätigungsorgan (14) aufweist, das dem Schaft (13) zum Verändern einer Axialposition des Schafts (13) und der Platte (12) zugeordnet ist.

3. Vakuumpumpe (10) nach irgendeinem vorhergehenden Anspruch, wobei die Platte (12) einen O-Ring (15) auf einer dem Pumpeneinlass zugewandten Oberfläche aufweist.

4. Vakuumpumpe (10) nach irgendeinem vorhergehenden Anspruch, wobei der Schaft (13) die Rotorwelle umfasst, die Platte (12) an einem Ende des Rotors zum Einlass hin montiert ist, wobei der Rotor in einer axialen Richtung mit Bezug auf den Stator beweglich montiert ist.

5. Vakuumpumpe (10) nach Anspruch 4, wobei der Rotor innerhalb der Pumpe über elektromagnetische Lager positioniert ist, wobei ein zu Elektromagneten, die den Lagern zugeordnet sind, zugeführter Strom eine Axialposition des Rotors und der Platte (12) steuert.

6. Vakuumpumpe (10) nach irgendeinem vorhergehenden Anspruch, wobei die Pumpe innere Laufräder aufweist, die auf der Welle koaxial mit dem axialen Kanal und um diesen verlaufend montiert sind, und äußere Laufräder aufweist, die auf einem Zylinder montiert sind, der um die inneren und äußeren Laufräder verläuft, wobei vorzugsweise die Vakuumpumpe eine Turbomolekularpumpe umfasst und die Laufräder Schaufeln aufweisen.

7. Vakuumpumpe (10) nach Anspruch 6 in Abhängigkeit von Anspruch 4 oder 5, wobei die inneren Laufräder und der Schaft (13) drehbar montiert sind und den Rotor bilden, und die äußeren Laufräder und der Zylinder größeren Durchmessers den Stator bilden.

8. Vakuumpumpe (10) nach Anspruch 6 in Abhängigkeit von einem der Ansprüche 1 bis 3, wobei die inneren Laufräder und der Schaft (13) den Stator bilden und die äußeren Laufräder und der Zylinder größeren Durchmessers drehbar montiert sind.

9. Vakuumpumpe (10) nach Anspruch 6, wobei sowohl die inneren als auch die äußeren Laufräder in entgegengesetzten Richtungen drehbar montiert sind.

10. Vakuumpumpe (10) nach irgendeinem vorhergehenden Anspruch, wobei die Vakuumpumpe eine Steuerschaltung aufweist, die zum Steuern einer axialen Position der Platte (12) konfiguriert ist, wobei vorzugsweise die Steuerschaltung einen Eingang aufweist, der zum Empfang eines Signals konfiguriert ist, das einen durch die Vakuumpumpe erzeugten Druck anzeigt, wobei die Steuerschaltung dafür konfiguriert ist, die axiale Position der Platte in Abhängigkeit von einem Wert des Signals zu steuern.

11. Vakuumpumpe (10) nach irgendeinem vorhergehenden Anspruch, mit einem Pumpengehäuse, wobei das Pumpengehäuse einen äußeren Zylinder, einen inneren Zylinder und eine Basis (11) umfasst, die senkrecht zu dem inneren und dem äußeren Zylinder verläuft und diese verbindet, wobei der innere Zylinder die genannte Leitung (32) bildet und sich weiter von der Basis (11) erstreckt als der äußere Zylinder.

12. Vakuumpumpe (10) nach irgendeinem vorhergehenden Anspruch, wobei ein Ende der Leitung (32) zum Pumpeneinlass hin Montagemittel zum Abstützen einer Substratmontageeinrichtung (24) umfasst.

13. Vakuumpumpe (10) nach irgendeinem vorhergehenden Anspruch, wobei die Pumpe aufweist:
eine Strömungssteuereinheit mit einem Einlass in Strömungsverbindung mit dem Auslass der Pumpe, wobei die Strömungssteuereinheit dafür konfiguriert ist, eine variable Leitfähigkeit an dem Auslass bereitzustellen und dadurch den Fluiddruck an dem Auslass der Pumpe zu steuern, wobei vorzugsweise die Strömungssteuereinheit weiter eine Steuerschaltung aufweist, die dafür konfiguriert ist, eine Drehzahl der Pumpe in Verbindung mit der Steuerung der Leitfähigkeit an dem Auslass zu steuern.

14. Vakuumanordnung mit einem Auslass für eine Vakuumkammer und einer Turbomolekular-Vakuumpumpe (10) nach irgendeinem vorhergehenden Anspruch, wobei ein Einlass der Turbomolekularpumpe mit dem Auslass für die Vakuumkammer (20) verbunden ist.

15. Vakuumkammer (20) mit einer Vakuumanordnung nach Anspruch 14, wobei der Substratträger (24) über die genannte Leitung (32) über mindestens einem Teil des Pumpeneinlasses hinaus verläuft.

## Revendications

1. Pompe (10) à vide comprenant :
un rotor ; et
un stator ;
une entrée pour recevoir un gaz pendant le fonctionnement ; et
un échappement pour évacuer ledit gaz ;
un conduit (32) définissant un passage axial s'étendant à travers ladite pompe (10) depuis une ouverture dans une base (11) de ladite pompe jusqu'à une ouverture axialement au-delà de ladite entrée de pompe, ledit rotor et ledit stator s'étendant autour dudit conduit (32),
**caractérisée en ce que**
une plaque (12) est configurée pour cacher ladite entrée d'une quantité pouvant être commandée et commander ainsi une conductance d'entrée de ladite pompe (10) ;
un arbre (13) pour monter ladite plaque (12) est creux et s'étend autour dudit passage ;
ladite plaque (12) comprend un trou dans une partie centrale à travers lequel ledit conduit (32) s'étend.

2. Pompe (10) à vide selon la revendication 1, dans laquelle
ladite plaque (12) comprend une plaque mobile axialement s'étendant dans au moins certaines positions axiales au-delà d'une entrée de ladite pompe (10), un changement de position axiale de ladite plaque (12) apportant un changement de conductance d'entrée de gaz à ladite pompe à vide, de préférence ladite pompe comprenant un actionneur (14) associé audit arbre (13) pour faire varier une position axiale dudit arbre (13) et de ladite plaque (12).

3. Pompe (10) à vide selon l'une quelconque des revendications précédentes, dans laquelle ladite plaque (12) comprend un joint torique (15) sur une surface faisant face à ladite entrée de pompe.

4. Pompe (10) à vide selon l'une quelconque des revendications précédentes, dans laquelle ledit arbre (13) comprend ledit arbre de rotor, ladite plaque (12) étant montée sur une extrémité dudit rotor vers ladite entrée, ledit rotor étant monté pour être mobile dans une direction axiale par rapport audit stator.

5. Pompe (10) à vide selon la revendication 4, dans laquelle ledit rotor est positionné dans ladite pompe via des paliers électromagnétiques, un courant fourni à des électroaimants associés auxdits paliers commandant une position axiale dudit rotor et de ladite plaque (12).

6. Pompe (10) à vide selon l'une quelconque des revendications précédentes, dans laquelle ladite pompe comprend des turbines intérieures montées sur ledit arbre coaxial avec et s'étendant autour dudit passage axial et des turbines extérieures montées sur un cylindre s'étendant autour desdites turbines intérieures et extérieures, de préférence ladite pompe à vide comprenant une pompe turbomoléculaire et lesdites turbines comprennent des aubes.

7. Pompe (10) à vide selon la revendication 6 lorsqu'elle est dépendante de la revendication 4 ou 5, dans laquelle lesdites turbines intérieures et ledit arbre (13) sont montés de manière rotative et comprennent ledit rotor et lesdites turbines extérieures et ledit cylindre de plus grand diamètre comprennent ledit stator.

8. Pompe (10) à vide selon la revendication 6, lorsqu'elle est dépendante de l'une quelconque des revendications 1 à 3, dans laquelle lesdites turbines intérieures et ledit arbre (13) comprennent ledit stator et lesdites turbines extérieures et ledit cylindre de plus grand diamètre sont montés de manière rotative.

9. Pompe (10) à vide selon la revendication 6, dans laquelle à la fois lesdites turbines intérieures et extérieures sont montées pour une rotation dans des directions opposées.

10. Pompe (10) à vide selon l'une quelconque des revendications précédentes, dans laquelle ladite pompe à vide comprend un ensemble de circuits de commande configuré pour commander une position axiale de ladite plaque (12), de préférence ledit ensemble de circuits de commande comprenant une entrée configurée pour recevoir un signal indiquant une pression produite par ladite pompe à vide, ledit ensemble de circuits de commande étant configuré pour commander ladite position axiale de ladite plaque en fonction d'une valeur dudit signal.

11. Pompe (10) à vide selon l'une quelconque des revendications précédentes, comprenant un corps de pompe, ledit corps de pompe comprenant un cylindre extérieur, un cylindre intérieur et une base (11) perpendiculaire auxdits et raccordant lesdits cylindres intérieur et extérieur, ledit cylindre intérieur comprenant ledit conduit (32) et s'étendant plus loin à partir de ladite base (11) que ledit cylindre extérieur.

12. Pompe (10) à vide selon l'une quelconque des revendications précédentes, dans laquelle une extrémité dudit conduit (32) vers ladite entrée de pompe comprend des moyens de montage pour supporter un dispositif de montage de substrat (24).

13. Pompe (10) à vide selon l'une quelconque des revendications précédentes, dans laquelle ladite pompe comprend :
une unité de commande d'écoulement ayant une entrée en connexion fluidique avec ledit échappement de ladite pompe, ladite unité de commande d'écoulement étant configurée pour apporter une conductance variable au niveau dudit échappement et commander ainsi une pression de fluide au niveau dudit échappement de ladite pompe, de préférence ladite unité de commande d'écoulement comprenant en outre un circuit de commande configuré pour commander une vitesse de ladite pompe conjointement avec la commande de ladite conductance au niveau dudit échappement.

14. Agencement à vide comprenant une sortie pour une chambre à vide et une pompe (10) à vide turbomoléculaire selon l'une quelconque des revendications précédentes, une entrée de ladite pompe turbomoléculaire étant raccordée à ladite sortie pour ladite chambre à vide (20).

15. Chambre à vide (20) comprenant un agencement à vide selon la revendication 14, dans laquelle ladite monture de substrat (24) s'étend au-delà dudit conduit (32) sur au moins une partie de ladite entrée de pompe.
